# EUROPEAN PATENT APPLICATION

(11) **EP 1 645 903 A1**
(43) Date of publication of application: **12.04.2006**
(21) Application number: 05021641.5
(22) Date of filing: 04.10.2005
(51) Int. Cl.: G02B 27/28, G03F 7/00

(54) **Wire grid polarizer and fabrication method thereof**

(30) Priority: 06.10.2004 KR 2004079683
(71) Applicant: LG Electronics Inc., Yongdungpo-gu Seoul (KR)
(72) Inventor: Lee, Ki-Dong, Bundang-Gu Seongnam Gyeonggi-Do (KR)
(74) Representative: von Hellfeld, Axel

(57) **Abstract**

A wire grid polarizer capable of increasing a visible light transmittance and a fabrication method thereof. The wire grid polarizer comprises a substrate (10) having a first surface and a second surface, a plurality of metallic wires (20-1) formed on the first surface, and grating patterns (10-1) formed on the second surface and having a grating period shorter than a half of a wavelength of an incident light beam.

## Description

### BACKGROUND OF THE INVENTION

### 1. Field of the Invention

The present invention relates to an optical device, and more particularly, to a wire grid polarizer and a fabrication method thereof.

### 2. Description of the Prior Art

Generally, a wire grid polarizer for polarizing an incident light beam in accordance with the related art is composed of a plurality of parallel metallic wires formed on a transparent glass substrate.

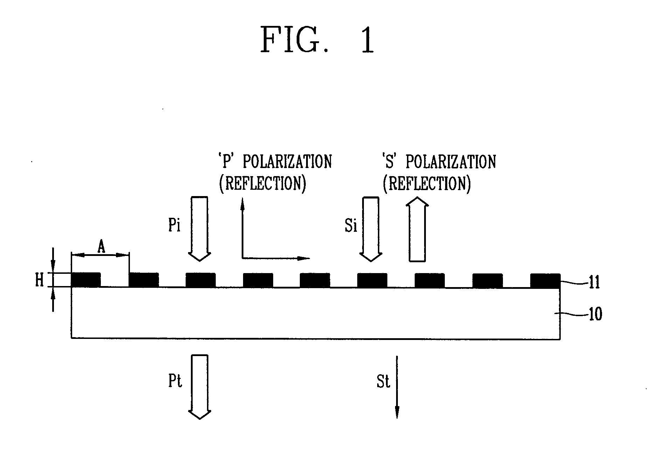

FIG. 1 is a view showing a structure of a wire grid polarizer in accordance with the related art.

As shown in FIG. 1, the related art wire grid polarizer comprises a transparent glass substrate 10, and a plurality of parallel wires (11) (metallic grids) formed on the transparent glass substrate 10. The 'A' denotes a grid spacing, 'H' denotes a grid height, 'Pi' denotes a 'P' polarization of an incident light beam, 'Si' denotes an 'S' polarization of an incident light beam, 'Pt' denotes a transmitted light beam of the 'P' polarization, and 'St' denotes a transmitted light beam of the 'S' polarization.

A function of the wire grid polarizer can be represented by a polarization extinction ratio and a light transmittance. In order for the wire grid polarizer to have a high polarization extinction ratio, a period of a metallic grid 11 has to be shorter than a wavelength of an incident light beam. For example, visible rays have a wavelength corresponding to 400nm~700nm. Therefore, a grid period of the wire grid polarizer used in the visible rays region has to be 200nm or less than 200nm in order to properly polarize an incident light beam. Since the grid period is not greatly shorter than a wavelength of a blue color, the polarization extinction ratio becomes lower as a wavelength of the incident light beam becomes shorter.

The polarization extinction ratio and the light transmittance of the wire grid polarizer are in inverse proportional with each other, and depend on a grid period, a grid height, and a grid width. Therefore, under the same polarization extinction ratio, a high light transmittance is required.

The wire grid polarizer is fabricated by forming metallic wires (metallic grids) on the transparent glass substrate by a lithography method. The light transmittance of the wire grid polarizer is determined by the metal wires and a reflectivity. For instance, when visible rays are vertically incident on the transparent glass substrate, approximately 4% of reflection loss is generated at an interface between air and glass. Accordingly, an anti-reflection coating is formed on an opposite surface to the surface of the transparent glass substrate where the metal wires are formed. However, multi-layer anti-reflection coatings (e.g. anti-reflection coatings with 4~5 layers) are necessary in order for the anti-reflection coating to be used in the visible rays region. Since the multi-layer anti-reflection coatings are formed by a vacuum deposition technique, it takes a lot of time and costs to form the multi-layer anti-reflection coatings.

As aforementioned, the related art wire grid polarizer has the problem that a reflection loss corresponding to approximately 4% is generated.

Since the multi-layer anti-reflection coatings are formed by a vacuum deposition technique, it takes a lot of time and costs to form the multi-layer anti-reflection coatings.

A wire grid polarizer in accordance with another related art is disclosed in U.S. Patent No. 6, 788, 461 dated September 7, 2004 and U.S. Patent No. 6, 243, 199 dated June 5, 2001.

### BRIEF DESCRIPTION OF THE INVENTION

Therefore, an object of the present invention is to provide a wire grid polarizer capable of enhancing a visible light transmittance.

Another object of the present invention is to provide a method for easily fabricating a wire grid polarizer capable of enhancing a visible light transmittance.

To achieve these and other advantages and in accordance with the purpose of the present invention, as embodied and broadly described herein, there is provided a wire grid polarizer, comprising: a substrate having a first surface and a second surface; a plurality of metallic wires formed on the first surface; and grating patterns formed on the second surface and having a grating period shorter than a half of a wavelength of an incident light beam.

According to another embodiment of the present invention, the wire grid polarizer comprises a substrate having a first surface and a second surface, a plurality of metallic wires formed on the first surface, and grating patterns formed on the second surface, in which the grating patterns are formed by etching the second surface.

To achieve these and other advantages and in accordance with the purpose of the present invention, as embodied and broadly described herein, there is also provided a method for fabricating a wire grid polarizer, comprising: forming metallic wires on a first surface of a substrate; and forming grating patterns on a second surface of the substrate, the grating patterns having a grating period shorter than a half of a wavelength of an incident light beam.

According to another embodiment of the present invention, the method for fabricating a wire grid polarizer comprises forming a plurality of metallic wires on a first surface of a substrate, and forming grating patterns on a second surface of the substrate, in which the grating patterns are formed by etching the second surface.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a view showing a structure of a wire grid polarizer in accordance with the related art;
FIG. 2 is a graph showing a relation between a grid period and a polarization extinction ratio of a wire grid polarizer according to the present invention;
FIGS. 3A to 3H are views showing a method for fabricating metallic wires applied to the wire grid polarizer of the present invention by a nano imprint lithography method;
FIG. 4 is a view showing a structure of a wire grid polarizer having grating patterns according to the present invention;
FIGS. 5A to 5D are views showing a structure of a wire grid polarizer having triangle-shaped grating patterns according to the present invention; and
FIG. 6 is a view showing reflectivity variation of the wire grid polarizer according to the present invention.

### DETAILED DESCRIPTION OF THE INVENTION

Reference will now be made in detail to the preferred embodiments of the present invention, examples of which are illustrated in the accompanying drawings.

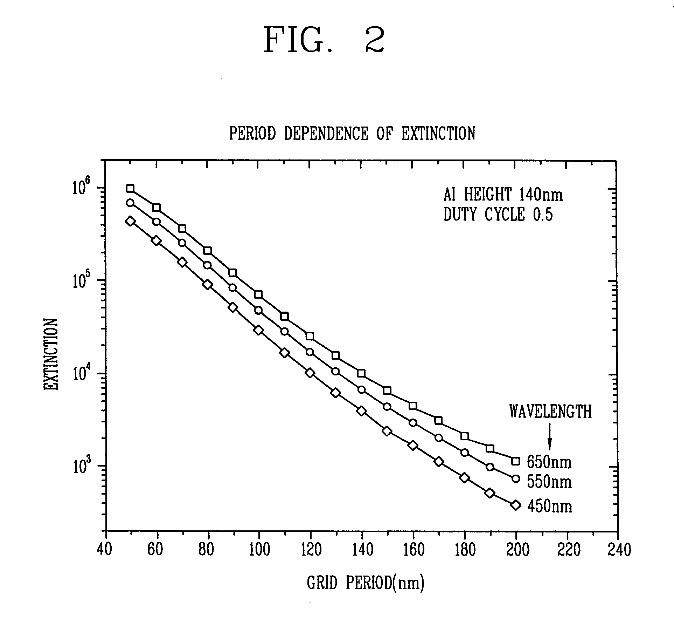

Hereinafter, a wire grid polarizer capable of enhancing a visible light transmittance and a fabrication method thereof capable of simplifying processes will be explained in more detail with reference to FIGS. 2 to 6.

FIG. 2 is a graph showing a relation between a grid period and a polarization extinction ratio of a wire grid polarizer according to the present invention.

As shown in FIG. 2, metallic wires of the wire grid polarizer according to the present invention are formed of aluminum, and each metallic wire has a height of 140 nm. Under an assumption that each of the metallic wires has a width corresponding to a half of a grid period (the grid period has to be less than a half of a wavelength of an incident light beam), a polarizing efficiency is increased as the grating period becomes shorter. For example, the grid period has to be 120 nm or less than 120 nm in order for the polarization extinction ratio to be 10, 000 or more than 10, 000 in wavelengths of Red (450 nm), Green (550 nm), and Blue (650 nm). In that case, the metallic wire has a width of 60 nm. The wire grid polarizer can be fabricated by a laser inference lithography method or a nano-imprint lithography method.

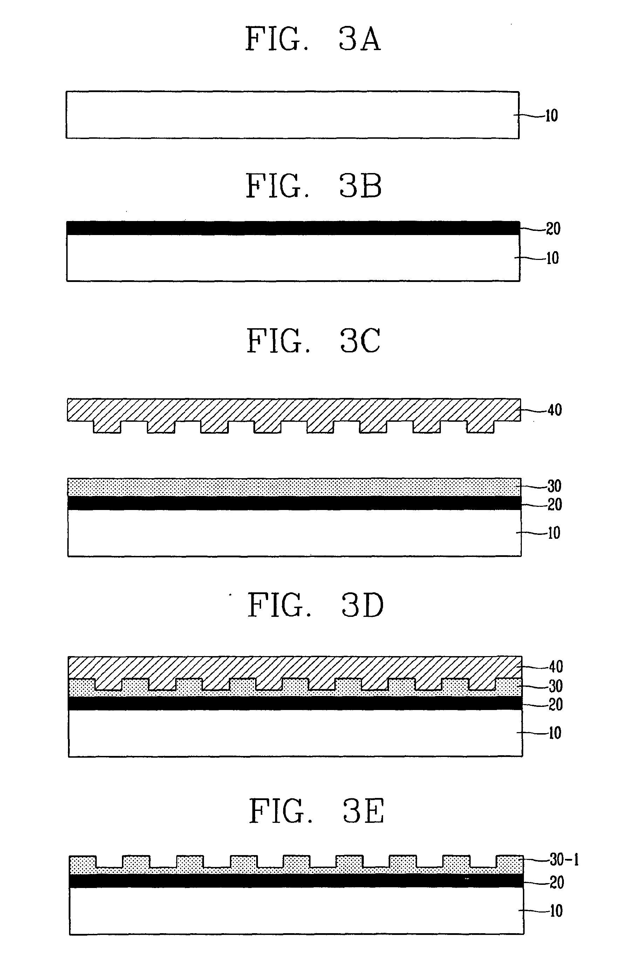

Hereinafter, a method for fabricating the metallic wires applied to the wire grid polarizer of the present invention by a nano-imprint lithography method will be explained with reference to FIGS. 3A to 3H.

FIGS. 3A to 3H are views showing a method for fabricating metallic wires applied to the wire grid polarizer of the present invention by a nano imprint lithography method.

As shown in FIGS. 3A and 3B, a metal thin film 20 is deposited on a transparent glass substrate 10 having polished front and rear surfaces. The metal thin film 20 may be formed of aluminum, silver, chrome, etc., and a transparent plastic substrate may be used instead of the transparent glass substrate 10.

As shown in FIGS. 3C and 3D, a polymer layer 30 is coated on the metal thin film 20, and then is patterned as a grating structure by using a prepared mold 40 having a grating structure. When the polymer layer 30 is patterned by using a thermal nano-imprint method, the polymer layer 30 is preferably pre-hardened (prebaked). On the contrary, when the polymer layer 30 is patterned by using a ultraviolet nano-imprint method, the coated polymer layer 30 is not pre-hardened but is preferably patterned by using a mold transparent against ultraviolet. For example, at the time of using the thermal nano-imprint method, the polymer layer 30 is pressed by using the mold 40 while a temperature of the transparent glass substrate 10 is increased more than a glass transition temperature of the polymer layer 30. On the contrary, at the time of using the ultraviolet nano-imprint method, the polymer layer 30 is pressed by using the mold 40 and ultraviolet exposure is performed through the mold 40 thereby to harden the polymer layer 30.

The mold 40 may be formed of silicone, silicon oxide, quartz glass, nickel, platinum, chrome, polymer material, etc.

As shown in FIG. 3E, when the mold 40 is separated from the polymer layer 30, polymer patterns 30-1 having a grating structure (e.g. square-shaped grating structure) are formed by the mold 40. At the time of using the thermal namo-imprint method, the mold 40 is preferably separated from the polymer patterns 30-1 after the transparent glass substrate 10 is cooled. On the contrary, at the time of using the ultraviolet nano-imprint method, the mold 40 is preferably separated from the polymer patterns 30-1 after completing the hardening by_ultraviolet.

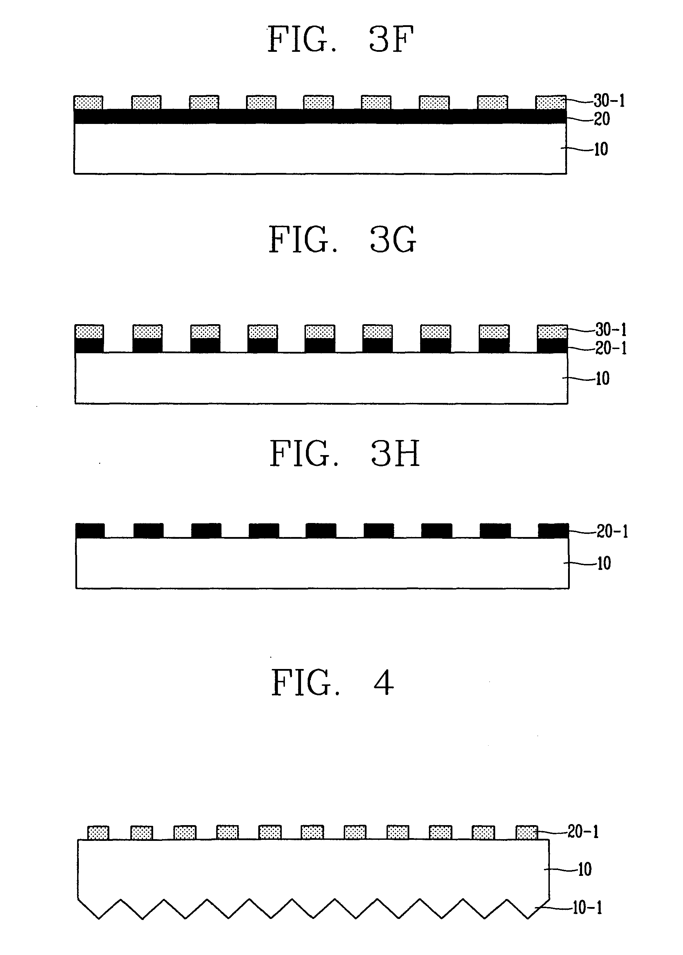

As shown in FIG. 3F, the polymer patterns 30-1 are dry-etched so that the metal thin film 20 can be partially exposed.

As shown in FIG. 3G, when the polymer patterns 30-1 are dry-etched, the transparent glass substrate 10 is partially exposed and the metallic grid 20 is formed as a grid structure. The polymer patterns 30-1 remain only on metallic thin films (metallic wires) 20-1 having the grid structure.

As shown in FIG. 3H, the polymer patterns 30-1 formed on the metallic thin films (metallic wires) 20-1 having the grid structure are removed by the dry-etching, thereby forming the metallic wires 20-1 on the transparent glass substrate.

However, since the wire grid polarizer is fabricated on the transparent glass substrate 10, a part of an incident light beam, approximately 4% is reflected due to a difference of a reflectivity between the front surface and the rear surface of the transparent glass substrate 10. Accordingly, in the wire grid polarizer of the present invention, grating patterns (e.g. triangle-shaped grating patterns) having a grating period shorter than a half of a wavelength of an incident light beam are formed on an opposite surface to the surface of the transparent glass substrate 10 where the metallic wires 20-1 are formed, thereby reducing the reflectivity and thus increasing the light transmittance. The grating patterns have a width increased towards inside of the transparent glass substrate 10.

Hereinafter, a structure of the wire grid polarizer according to the present invention will be explained in more detail with reference to FIG. 4.

FIG. 4 is a view showing a structure of a wire grid polarizer having grating patterns according to the present invention.

As shown in FIG. 4, the wire grid polarizer having grating patterns comprises a transparent substrate 10 having a first surface (e.g. a front surface) and a second surface (e.g. a rear surface), a plurality of metallic wires 20-1 (metallic grids) formed on the first surface, and grating patterns 10-1 formed on the second surface and having a grating period shorter than a half of a wavelength of an incident light beam. The metallic wires are preferably formed in correspondence with a direction of the grating patterns (e.g. triangle-shaped grating patterns).

The grating patterns may have various structures such as a triangle-shaped structure, a semioval-shaped structure, an arc-shaped structure, a semicircle-square shaped structure, etc. However, the grating patterns preferably have the triangle-shaped structure since the triangle-shaped structure enables the grating patterns to have a width drastically increased towards inside of the transparent glass substrate 10. Accordingly, a wire grid polarizer having the triangle-shaped grating structure will be explained hereinafter.

According to the wire grid polarizer having the triangle-shaped grating structure, a non-consecutive change of the refractive index is removed by consecutively changing the refractive index of the transparent glass substrate, thereby reducing the reflectivity. According to an experiment result of the present invention, the wire grid polarizer of the present invention has a reflection loss less than 0.5% whereas the related art wire grid polarizer has a reflection loss of 4%.

The reason why the wire grid polarizer has to have a grating period less than the half of a wavelength of an incident light beam is in order to remove diffraction due to the triangle-shaped grating patterns. That is, under an assumption that a visible ray has a wavelength of 400 nm ~ 600 nm, the grating period of the wire grid polarizer has to be 200 nm or less than 200nm. As the height of the grating pattern becomes higher, the refraction index of the transparent glass substrate is gradually changed thereby to have an advantage. When the wire grid polarizer has a grating period of 200 nm or less than and the grating pattern has a depth of 200 nm or less than, the transparent glass substrate 10 has a reflectivity less than 0.5%.

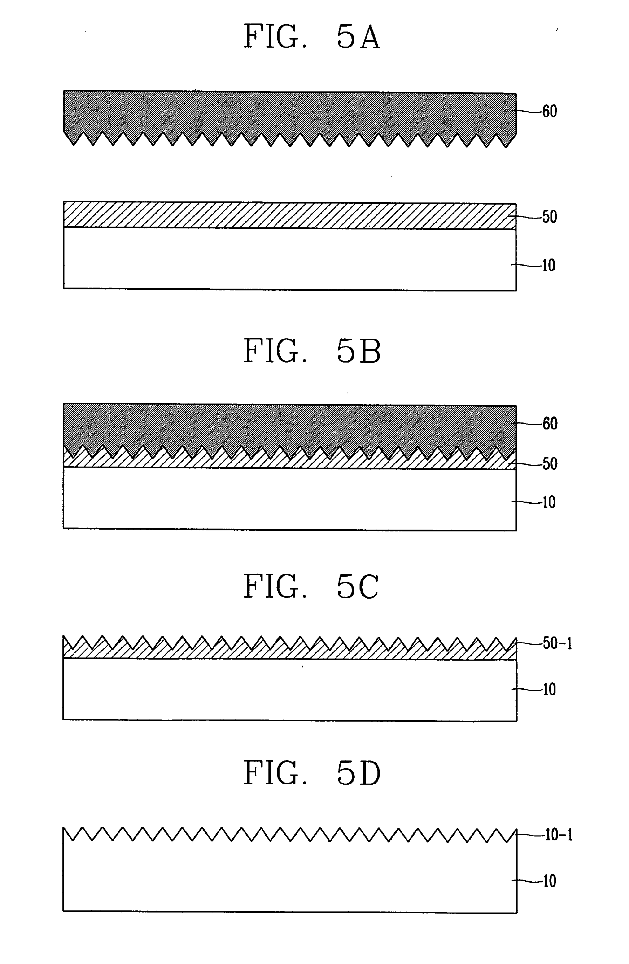

Hereinafter, a method for easily fabricating a wire grid polarizer according to the present invention will be explained with reference to FIGS. 5A to 5D. The triangle-shaped grating patterns can be easily formed by using the nano-imprint lithography method in the same manner as the method for fabricating the metallic wires.

FIGS. 5A to 5D are views showing a structure of a wire grid polarizer having triangle-shaped grating patterns according to the present invention.

As shown in FIGS. 5A and 5B, a polymer layer 50 is formed on the transparent glass substrate 10. Then, the polymer layer 50 is pressed by using a prepared mold 60 having a triangle-shaped grating structure.

As shown in FIG. 5C, when the mold 60 is separated from the polymer layer 50 after the polymer layer 50 is hardened, polymer patterns 50-1 of a triangle-shaped grating structure having a grating period less than a half of a wavelength of an incident light beam are formed on the transparent glass substrate 10.

As shown in FIG. 5D, the entire surface of the polymer patterns 50-1 are dry-etched so that a second surface of the transparent glass substrate 10 can be exposed. As the result, triangle-shaped grating patterns 10-1 having a grating period less than a half of a wavelength of an incident light beam (e.g. 200 nm) are formed on the second surface (the rear surface) of the transparent glass substrate 10. As the second surface (the rear surface) of the transparent glass substrate 10 is etched, the triangle-shaped grating patterns 10-1 are formed.

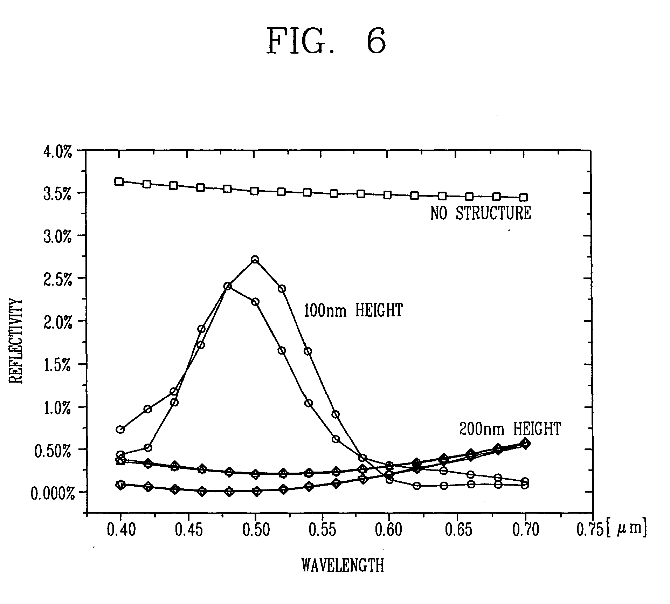

Hereinafter, a reflectivity of the wire grid polarizer to which grating patterns having a grating period of 200 nm are applied will be explained with reference to FIG. 6.

FIG. 6 is a view showing reflectivity variation of the wire grid polarizer according to the present invention.

As shown in FIG. 6, the reflectivity of the wire grid polarizer according to the present invention is varied according to a polarization. A polarization perpendicular to grating patterns has a small reflectivity. Also, a grating pattern having a height of 200 nm has a smaller reflectivity than a grating pattern having a height of 100 nm. Therefore, each grating pattern 10-1 applied to the wire grid polarizer of the present invention is preferably spaced apart on the transparent glass substrate 10 at a grating period of 200 nm or less than 200 nm. Also, each grating pattern 10-1 applied to the wire grid polarizer of the present invention preferably has a height of 200 nm or more than 200 nm, and has a width less than 60% of the grating period. For example, when the grating period is 200 nm, the grating pattern has a width of 120 nm or less than 120 nm, and when the grating period is 100 nm, the grating pattern has a width of 60 nm or less than 60 nm.

The grating patterns applied to the present invention can be fabricated by the laser interference lithography method or the nano-imprint lithography method or other various lithography methods.

As aforementioned, in the wire grid polarizer and the fabrication method thereof according to the present invention, the grating patterns are formed at the opposite surface to the surface of the transparent glass substrate where the metallic wires are formed, thereby increasing the visible light transmittance.

In the wire grid polarizer and the fabrication method thereof according to the present invention, the grating patterns are formed by using the lithography method thereby to simplify fabrication processes for the wire grid polarizer.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A wire grid polarizer, comprising:
a substrate having a first surface and a second surface;
a plurality of metallic wires formed on the first surface; and
grating patterns formed on the second surface and having a grating period shorter than a half of a wavelength of an incident light beam.

2. The wire grid polarizer of claim 1, wherein the grating patterns are triangle-shaped grating patterns.

3. The wire grid polarizer of claim 1, wherein the grating patterns are formed by etching the second surface.

4. The wire grid polarizer of claim 3, wherein the grating patterns have a triangle-shaped structure.

5. The wire grid polarizer of claim 1, wherein the grating patterns have a width increased towards inside of the substrate.

6. The wire grid polarizer of claim 1, wherein the grating patterns have a width less than 60% of the grating period.

7. The wire grid polarizer of claim 1, wherein the grating patterns have one structure among a triangle-shaped structure, a semioval-shaped structure, an arch-shaped structure, and a semicircle-square shaped structure.

8. The wire grid polarizer of claim 1, wherein the grating period is less than 200 nm.

9. The wire grid polarizer of claim 1, wherein the grating patterns have a height corresponding to 100 nm to 200 nm.

10. The wire grid polarizer of claim 1, wherein the grating patterns are formed by a lithography method.

11. A wire grid polarizer, comprising:
a substrate having a first surface and a second surface;
a plurality of metallic wires formed on the first surface; and
grating patterns formed on the second surface, in which the grating patterns are formed by etching the second surface.

12. The wire grid polarizer of claim 11, wherein the grating patterns are triangle-shaped grating patterns.

13. The wire grid polarizer of claim 12, wherein the triangle-shaped grating patterns have a grating period shorter than a half of a wavelength of an incident light beam.

14. The wire grid polarizer of claim 11, wherein the plurality of metallic wires are formed in correspondence with a direction of the triangle-shaped grating patterns.

15. A method for fabricating a wire grid polarizer, comprising:
forming metallic wires on a first surface of a substrate; and
forming grating patterns on a second surface of the substrate, the grating patterns having a grating period shorter than a half of a wavelength of an incident light beam.

16. The method of claim 15, wherein the grating patterns are triangle-shaped grating patterns.

17. The method of claim 15, wherein the grating patterns are formed by etching the second surface.

18. The method of claim 15, wherein the grating patterns have a width increased towards inside of the substrate.

19. The method of claim 15, wherein the grating patterns have one structure among a triangle-shaped structure, a semioval-shaped structure, an arch-shaped structure, and a semicircle-square shaped structure.

20. The method of claim 15, wherein the grating period is 200 nm or less than 200 nm.

21. The method of claim 15, wherein the grating patterns have a height corresponding to 100 nm to 200 nm.

22. The method of claim 15, wherein the grating patterns are formed by a lithography method.

23. The method of claim 15, wherein the step of forming grating patterns comprises:
forming a polymer layer on the substrate;
pattering the polymer layer as a grating structure; and
etching the patterned grating structure so that the surface of the substrate can be exposed.

24. A method for fabricating a wire grid polarizer, comprising:
forming a plurality of metallic wires on a first surface of a substrate; and
forming grating patterns on a second surface of the substrate, in which the grating patterns are formed by etching the second surface.

25. The method of claim 24, wherein the grating patterns are triangle-shaped grating patterns.

26. The method of claim 25, wherein the triangle-shaped grating patterns have a grating period shorter than a half of a wavelength of an incident light beam.
